# EUROPÄISCHE PATENTSCHRIFT

(11) **EP 2 720 248 B1**
(45) Veröffentlichungstag und Bekanntmachung des Hinweises auf die Patenterteilung: **23.08.2017**
(21) Anmeldenummer: 14150384.7
(22) Anmeldetag: 11.03.2008
(51) Int. Cl.: H01J 37/305, H01J 37/32

(54) **VAKUUM-LICHTBOGENVERDAMPFUNGSQUELLE, SOWIE EINE LICHTBOGENVERDAMPFUNGSKAMMER MIT EINER VAKUUM -LICHTBOGENVERDAMPFUNGSQUELLE**
VACUUM ARC EVAPORATION SOURCE, AND ARC EVAPORATION CHAMBER WITH A VACUUM ARC EVAPORATION SOURCE
SOURCE DE VAPORISATION D'ARCS ÉLECTRIQUES À VIDE AINSI QUE CHAMBRE DE VAPORISATION D'ARCS ÉLECTRIQUES DOTÉE D'UNE SOURCE DE VAPORISATION D'ARCS ÉLECTRIQUES À VIDE

(30) Priorität: 17.04.2007 EP 07106345
(43) Veröffentlichungstag der Anmeldung: 16.04.2014
(62) Teilanmeldung aus: 08717591.5
(73) Patentinhaber: Oerlikon Surface Solutions AG, Pfäffikon, 8808 Pfäffikon SZ (CH)
(72) Erfinder: Vetter, Jörg, 51469 Bergisch Gladbach (DE)
(74) Vertreter: Intellectual Property Services GmbH

(56) Entgegenhaltungen:
- DE-A1- 19 739 527
- US-A- 5 298 136

## Beschreibung

Die Erfindung betrifft eine Vakuum Lichtbogenverdampfungsquelle, sowie eine Lichtbogenverdampfungskammer mit einer Vakuum Lichtbogenverdampfungsquelle gemäss dem Oberbegriff des unabhängigen Anspruchs 1. Aus dem Stand der Technik sind eine Vielzahl von Vakuum Lichtbogenverdampfungsanlagen bekannt, bei welchen eine Bogenentladung mit einem Verdampfungsmaterial, das als Kathode ausgebildet ist, in einer Vakuumkammer erzeugt wird, wodurch das Verdampfungsmaterial durch die Energie eines Lichtbogens verdampft und ganz oder teilweise ionisiert wird, um dünne Filme auf einem Substrat abzulagern.
Dabei können derartig abgelagerte Filme ganz unterschiedliche Funktionen erfüllen. Sie können rein dekorative Zwecke erfüllen, gegen Verschleiss oder Korrosion schützen oder die Oberflächen von Werkstücken gegen grosse Hitzeeinwirkungen abschirmen usw.. Häufig erfüllen die mittels Lichtbogenverdampfung aufgebrachten Schichten zwei oder mehr, oft unterschiedliche Funktionen gleichzeitig. Dementsprechend ist es seit langem bekannt auch mehrlagige Schichtsysteme gleicher oder verschiedener Zusammensetzung aufzubringen.

So ist z.B. in der DD 293 145 ein Verfahren und eine Vorrichtung zur Herstellung von Mehrkomponentenschichten offenbart, bei welchen eine aus mehreren Arbeitsflächen bestehende Kathode verwendet wird, an welche ein örtlich und zeitlich veränderbares Magnetfeld angelegt wird, so dass der Kathodenbrennfleck entsprechend der geforderten Schichtzusammensetzung auf die verschiedenen Arbeitsflächen gezwungen wird.

Ein damit verwandtes Verfahren sowie eine entsprechende Vorrichtung ist in der DD 285 463 gezeigt, um ein gleichmässigeres Abbrennen der Kathoden zu gewährleisten, was z.B. auch beim Aufbringen von einfachen einlagigen Schichtsystemen vorteilhaft eingesetzt werden kann.

Ganz gleich ob einlagige oder mehrlagige Schichtsysteme aufgebracht werden sollen, haben alle derartigen und ähnliche aus dem Stand der Technik bekannten Vakuum Lichtbogenverdampfungsanlagen verschiedene entscheidende Nachteile.

So werden bei den bekannten Lichtbogenverdampfern zwangsläufig geschmolzene Partikel mit einem Durchmesser von bis zu einigen Mikrometern oder mehr gebildet, die deutlich grösser sind als die eigentlich gewünschten kleinen verdampften und ionisierten Partikel. Diese wesentlich grösseren Partikel werden dann in die Schichten bzw. dünnen Filme eingemischt, was zu einer Verschlechterung der Oberflächenstruktur, der Festigkeit, der Haftfestigkeit, der tribologischen Eigenschaften usw. der Filme führt, und bei ein- und mehrlagigen Schichten zu einer ungleichmässigen Zusammensetzung der aufgebrachten Schichten führen kann.

Um das zu verhindern wurde z.B. in der JP 2 194 167 vorgeschlagen, eine zu der Verdampfungsfläche koaxiale Spule mit einem Luftkern zwischen der Verdampfungsfläche und einem Substrat anzuordnen. Dadurch werden Elektronen in einem Plasma um die von der Spule erzeugten magnetischen Kraftlinien gezwungen und fliessen entlang der Kraftlinien, während sie eine Drehbewegung ausführen, so dass das Plasma das Substrat erreicht. Dieser Induktionseffekt wirkt allerdings natürlich nicht auf neutrale geschmolzene Partikel. Ein weiterer entscheidender Nachteil dieser Anordnung ist, dass die Spule in einer Zwischenposition zwischen dem Substrat und der Verdampfungsoberfläche angeordnet ist, was dazu führt, dass das von der Spule erzeugte Magnetfeld radial in Bezug auf die Verdampfungsoberfläche nach Innen gerichtet ist. Das hat zur Folge, dass der Lichtbogen tendenziell näher zur Mitte der Kathode geführt wird, so dass diese ungleichmässig verbraucht wird. Ausserdem werden weitere Verdampfungsquellen, die in bestimmten Fällen zusätzlich in der Kammer angeordnet sein können, z.B. um mehrlagige Schichten oder Schichten von komplizierter Zusammensetzung herzustellen, durch die Magnetspule negativ beeinflusst, was natürlich zu unerwünschten Effekten führen kann.

In der europäischen Patentanmeldung EP 0 495 447 wird daher vorgeschlagen, auf der Rückseite des Kathodenkörpers eine zusätzlich Magnetfeldquelle vorzusehen, die an einen Motor gekoppelt ist, so dass ein von der zusätzlichen Magnetfeldquelle erzeugtes Magnetfeld räumlich und zeitlich variiert werden kann, so dass der Lichtbogen gezielt auf der Verdampferoberfläche geführt werden kann, und so z.B. ein gleichmässigeres Abbrennen der Kathode gewährleistbar ist. Der Nachteil dieser Anordnung ist natürlich, dass die Konstruktion sehr aufwendig in Aufbau, Betrieb und Wartung ist. Darüber hinaus werden ebenfalls Streufelder erzeugt, die zudem noch räumlich und zeitlich variieren, und benachbarte Verdampferkathoden unerwünschten Einflüssen aussetzen können.

Zur Lösung dieser aus dem Stand der Technik bekannten Probleme wird in der DE 600 19 821 vorgeschlagen, eine ringförmige Magnetfelderzeugungsquelle so anzuordnen, dass sie das Verdampfungsmaterial umringt und die Verdampfungsoberfläche zwischen dem Nord- und dem Südpol der Magnetfelderzeugungsquelle vorgesehen wird. Dafür werden zwei Magnetfelderzeugungsquellen , eine innere und eine äußere, um die Bogenentladungsquelle gruppiert. Die magnetischen Kraftlinien der Magnetfelderzeugungsquelle sollen dabei unter einem Winkel von +/- 30° in Bezug auf die Normale die Verdampferoberfläche kreuzen.

Dabei ist bevorzugt auf der der Verdampfungsoberfläche abgewandeten Seite der Verdampferkathode eine scheibenförmige Magnetfeldquelle in der Mitte an der Unterseite des Kathodenkörpers vorgesehen, wodurch die magnetischen Feldlinien der ringförmigen Magnetfelderzeugungsquelle derart verändert werden sollen, dass der Lichtbogen auf der Verdampfungsoberfläche so geführt wird, dass ein ungleichmässiges Abtragen der Verdampferoberfläche verhindert werden soll. Erfahrungsgemäß bewirkt jedoch eine Positionierung eines Magneten im Zentrum eine Feldverstärkung genau in der Mitte der Kathodenoberfläche.
Das System ist bedingt durch seinen Aufbau unflexibel. Das heisst, insbesondere wenn Permanentmagnetquellen verwendet werden, kann die Feldstärke und die Feldstärkenverteilung an der Kathode praktisch nicht mehr verändert werden. Somit kann das System nicht an äussere Einflüsse, z.B. durch benachbarte magnetische Quellen, nicht an andere Stromdichten im Lichtbogen, nicht an unterschiedliche Kathodenmaterialien, oder an andere den Beschichtungs- bzw. den Abbrandprozess an der Kathode bestimmenden Einflüsse angepasst werden.
Die gattungsgemässe WO 2004/057642 A2 beschreibt eine Vakuum Lichtbogenverdampfungsquelle mit einer ringförmigen Magnetfeldquelle und einen Kathodenkörper mit einem Verdampfungsmaterial als Kathode zur Erzeugung einer Lichtbogenentladung auf einer Verdampfungsoberfläche der Kathode. Ein Magnetfeldverstärkungsring ist auf einer Verdampfungsoberfläche abgewandten Seite vor einem Kathodenboden angeordnet. Ein Innendurchmesser des Magnetverstärkungsrings entspricht ungefähr einem Durchmesser der Kathode.

In der US 5 298 136 A wird eine Vakuum Lichtbogenverdampfungsquelle mit einer ringförmigen Magnetfeldquelle und einen Kathodenkörper mit einem Verdampfungsmaterial als Kathode zur Erzeugung einer Lichtbogenentladung auf einer Verdampfungsoberfläche der Kathode beschrieben.

Die DE 197 39 527 A1 beschreibt eine Vakuumbogen-Plasmaquelle mit einer Fokus- und eine oder mehrere Steuerspulen, wobei die Steuerspulen auf einer der Verdampfungsoberfläche abgewandten Seite in einem vorgebbaren zweiten Abstand vor dem Kathodenboden angeordnet sind.
Die Aufgabe der Erfindung ist es daher, eine verbesserte Vakuum Lichtbogenverdampfungsquelle, sowie eine verbesserte Lichtbogenverdampfungskammer bereit zu stellen, die insbesondere eine Magnetfeldverstärkung in Richtung zu den Substraten realisiert, gleichzeitig eine Verstärkung des Magnetfeldes an der inneren Kathodenoberfläche garantiert, so dass einerseits ein homogener Verlauf über den Kathodenabbrand erreichbar ist und ein vorteilhafter Verlauf, des Magnetfeldes an der Kathodenoberfläche erricht wird, so dass eine optimale Beschleunigung des Lichtbogens möglich wird.
Eine übermäßige Feldverstärkung in der Mitte der Kathodenoberfläche soll dabei vermieden werden.
Dabei soll das verbesserte System gleichzeitig sehr flexibel in Bezug auf die Möglichkeiten der Veränderungen der Magnetfeldgeometrie sein, so dass auf einfache und wirtschaftliche Weise die Lichtbogenverdampfungsquelle bzw. die damit ausgerüstete Lichtbogenverdampfungskammer jederzeit optimal an wechselnde Anforderungen angepasst werden kann.
Die diese Aufgaben lösenden Gegenstände der Erfindung sind durch die Merkmale des unabhängigen Anspruchs 1 gekennzeichnet.
Die jeweiligen abhängigen Ansprüche beziehen sich auf besonders vorteilhafte Ausführungsformen der Erfindung.
Die Erfindung betrifft somit eine Vakuum Lichtbogenverdampfungsquelle, umfassend eine ringförmige Magnetfeldquelle und einen Kathodenkörper mit einem Verdampfungsmaterial als Kathode zur Erzeugung einer Lichtbogenentladung auf einer Verdampfungsoberfläche der Kathode. Dabei ist der Kathodenkörper in einer ersten axialen Richtung von einem Kathodenboden und in einer zweiten axialen Richtung von der Verdampfungsoberfläche in axialer Richtung begrenzt, und die ringförmige Magnetfeldquelle parallel oder antiparallel zu einer Flächenormalen der Verdampfungsoberfläche polarisiert und konzentrisch zu der Flächennormalen der Verdampfungsoberfläche angeordnet. Ein Magnetfeldverstärkungsring ist auf einer der Verdampfungsoberfläche abgewandten Seite in einem vorgebbaren zweiten Abstand vor dem Kathodenboden angeordnet. In der Vakuum Lichtbogenverdampfungsquelle ist zusätzlich zum Magnetfeldverstärkungsring mindestens ein magnetischer Korrekturring auf der der Verdampfungsoberfläche abgewandten Seite in einem vorgebbaren dritten Abstand vor dem Kathodenboden angeordnet. Durch den magnetischen Korrekturring ist es möglich, eine Feinabstimmung der Geometrie der Magnetfeldverteilung vorzunehmen, so dass auch in komplizierten Fällen eine optimale Führung des Lichtbogens auf der Verdampfungsoberfläche gewährleistet ist.
Dabei kann die die Magnetfeldquelle derart konzentrisch zu der Flächennormalen der Verdampfungsoberfläche angeordnet sein, dass die Verdampfungsoberfläche zwischen einem Nordpol und einem Südpol der Magnetfeldquelle liegt. D.h., in einem ganz speziellen Ausführungsbeispiel umschliesst die ringförmige Magnetfeldquelle die Verdampferoberfläche der Kathode zum Beispiel so, dass die Verdampfungsoberfläche ungefähr den gleichen Abstand zum Südpol der ringförmigen Magnetfeldquelle hat, wie zum Nordpol der ringförmigen Magnetfeldquelle.
In einem für die Praxis ganz besonders wichtigen Ausführungsbeispiel ist die ringförmige Magnetfeldquelle jedoch in einem vorgebbaren ersten Abstand auf einer vom Kathodenboden abgewandten Seite des Kathodenkörpers von der Verdampfungsoberfläche beabstandet.
Es hat sich nämlich überraschend gezeigt, dass dadurch, dass wenn die Verdampfungsoberfläche nicht zwischen dem Nord- und dem Südpol der ringförmigen Magnetfeldquelle angeordnet ist, sondern von dieser in einem vorgebbaren Abstand beabstandet ist, eine noch optimalere Feldverteilung im Bereich des Kathodenkörpers, insbesondere im Bereich der Verdampfungsoberfläche erreichbar ist. Trotzdem kann es bestimmte spezielle Anwendungsbeispiele geben, in dem eine Anordnung der Verdampfungsoberfläche zwischen Nordpol und Südpol der ringförmigen Magnetfeldquelle vorzuziehen ist.
Für die überwiegende Zahl der Anwendungen hat sich jedoch überraschend gezeigt, dass dadurch, dass wenn einerseits die Verdampfungsoberfläche nicht zwischen dem Nord- und dem Südpol der ringförmigen Magnetfeldquelle angeordnet ist, sondern von dieser in einem vorgebbaren Abstand beabstandet ist, und andererseits anstatt einer bekannten scheibenförmigen, in der Mitte unterhalb des Kathodenkörpers angeordneten magnetischen Quelle, ein ringförmiger Magnetfeldverstärkungsring vorgesehen wird, eine optimale Feldverteilung im Bereich des Kathodenkörpers, insbesondere im Bereich der Verdampfungsoberfläche erreichbar ist, die die aus dem Stand der Technik bekannten Nachteile nicht zeigt.

Durch diese Anordnung wird insbesondere im Bereich der Mitte der Kathode ein im Vergleich zum Stand der Technik deutlich gleichmäßigeres Feld erzeugt. Dadurch wird erreicht, dass die Kathode sehr gleichmässig verbraucht wird, also über die gesamte Verdampfungsfläche gleichmässig abbrennt, wobei dieser positive Effekt gleichzeitig nicht zu Lasten der zur Verdampferoberfläche parallelen Magnetfeldkomponenten geht, die hauptsächlich zur Beschleunigung der Bewegung des Lichtbogens dienen. Das heisst, durch diese Anordnung wird letztlich die Führung des Lichtbogens auf der Verdampfungsoberfläche wesentlich verbessert, was unter anderem zu einem viel gleichmässigeren Abbrand der Kathode und deutlich besseren Beschichtungsergebnissen führt.
Darüber hinaus wird gleichzeitig das Magnetfeld in Richtung zu den Substraten erhöht, was sich letztlich sehr positiv auf die Beschichtungsqualität beim Beschichten eines Substrats auswirkt.
Dies wird durch das Positionieren der Magnetfeldquelle in der Kathodenoberfläche bzw. in einem Abstand zu dieser in Richtung der Substrate erreicht.

Ausserdem ist die Lichtbogenverdampfungsquelle bzw. die Lichtbogenverdampfungskammer gemäss der vorliegenden Erfindung bedingt durch ihren Aufbau sehr flexibel. Durch die Verwendung von Permanentmagnetquellen zumindest für den Magnetfeldverstärkungsring kann die Feldstärke und die Feldstärkenverteilung an der Kathode sehr einfach verändert werden. Somit kann das erfindungsgemässe System leicht an eine Veränderung äusserer Einflüsse, z.B. durch benachbarte magnetische Quellen, an andere Stromdichten im Lichtbogen, an unterschiedliche Kathodenmaterialien, oder an andere den Beschichtungs- bzw. den Abbrandprozess an der Kathode bestimmenden Einflüsse angepasst werden.
Von besonderem Vorteil ist dabei die modulare Bauweise der Lichtbogenverdampfungsquelle gemäss der vorliegenden Erfindung. Bevorzugt besteht eine erfindungsgemässe Lichtbogenverdampfungsquelle nämlich aus einem getrennten System von inneren Magneten und der Verdampfergrundplatte mit dem zweiten Magnetsystem, so dass die Magnetsysteme separat und unabhängig voneinander manipuliert bzw. verändert oder ausgetauscht werden können.
In einem bevorzugten Ausführungsbeispiel ist der Magnetfeldverstärkungsring parallel oder antiparallel zur Flächennormalen) polarisiert und / oder konzentrisch zur Flächennormalen angeordnet.
Es versteht sich, dass je nach gewünschter magnetischer Feldvereilung bzw. räumlicher Verteilung des Magnetfeldverlaufs der magnetische Korrekturring parallel oder antiparallel zur Flächennormalen polarisiert sein kann und / oder bevorzugt konzentrisch zur Flächennormalen angeordnet ist.
Für bestimmte spezielle Anwendungsfälle ist es auch möglich, dass der Magnetfeldverstärkungsring und / oder der magnetische Korrekturring nicht-konzentrisch zur Flächennormalen ausgerichtet ist und / oder der Magnetfeldverstärkungsring und / oder der magnetische Korrekturring eine nicht-kreisförmige Querschnittsfläche hat. Mit solchen Anordnungen lassen sich hoch komplexe Magnetfeldgeometrien im Bereich des Kathodenkörpers konstruieren, so dass zum Beispiel beim Beschichten von mehreren Substraten die Magnetfelder in Richtung zu den unterschiedlichen Substraten verschieden stark sein können, so dass verschiedene Substrate gleichzeitig von derselben Quelle unter verschiedenen Bedingungen beschichtet werden können. Oder es kann z.B. vorteilhaft dann eingesetzt werden, wenn die Kathode verschiedene Bereiche mit verschiedenen Beschichtungsmaterialien umfasst, so dass eine entsprechend komplizierte Führung des Lichtbogens auf der Verdampfungsoberfläche notwendig ist.
Ebenfalls für die Praxis sehr bedeutend sind Ausführungsbeispiele erfindungsgemässer Vakuum Lichtbogenverdampfungsquellen, bei welchen der erste Abstand und / oder der zweite Abstand und / oder der dritte Abstand einstellbar ist, insbesondere in Abhängigkeit vom Verdampfungsmaterial und / oder vom Abbrandzustand der Kathode und / oder in Abhängigkeit von einem anderen Betriebsparameter der Vakuum Lichtbogenverdampfungsquelle steuerbar und / oder regelbar ist, wodurch die Vakuum Lichtbogenverdampfungsquelle eine bisher nicht bekannte Flexibilität in Bezug auf alle möglichen Betriebszustände und Verfahrensanforderungen erhält.
Der erste Abstand und / oder der zweite Abstand und / oder der dritte Abstand können dabei bevorzugt in einem Bereich von 0 mm bis 200 mm liegen. Wie oben bereits erwähnt ist dabei für die Erfindung massgebend, dass die Verdampfungsoberfläche nicht direkt zwischen den Nordpol und den Südpol einer der eingesetzten Magnetfeldquellen zu liegen kommt, da dann die erfindungsgemässe optimale Feldverteilungsgeometrie nicht erreichbar ist.
Die unterschiedlichen, oben bereits im Detail eingeführten Magnetfeldquellen können dabei durch verschiedene Konzepte konkret realisiert sein. Erfindungsgemäß umfasst der Magnetfeldverstärkungsring eine Mehrzahl von im Wesentlichen parallel zur Flächennormalen ausgerichteten Permanentmagneten. Die ringförmige Magnetfeldquelle und / oder der magnetische Korrekturring können in einem besonders bevorzugten Ausführungsbeispiel eine Mehrzahl von im wesentlichen parallel zur Flächennormalen ausgerichtete Permanentmagnete umfassen. Im wesentlichen parallel heisst dabei, dass der Winkel zwischen der Flächennormalen der Verdampfungsoberfläche und einer Polarisationsrichtung der Permanentmagnete z.B. zwischen 0° und 20°, bevorzugt jedoch bei 0° liegt.

Dabei kann die ringförmige Magnetfeldquelle und / oder der magnetische Korrekturring auch einen Ringmagneten umfassen, der bevorzugt im wesentlichen parallel zur Flächennormalen der Verdampfungsoberfläche polarisiert ist.
In einem anderen Ausführungsbeispiel kann die ringförmige Magnetfeldquelle und / oder der magnetische Korrekturring einen Elektromagneten umfassen. Bei Verwendung eines Elektromagneten kann natürlich die Stärke und Geometrie der Magnetfeldlinien besonders flexibel an spezielle Anforderungen angepasst werden.
Ganz allgemein ist in verschiedenen, für die Praxis sehr wichtigen Ausführungsbeispielen eine Magnetfeldstärke der ringförmigen Magnetfeldquelle und / oder eine Magnetfeldstärke des magnetischen Korrekturrings veränderbar und / oder steuerbar und / oder regelbar ist, insbesondere in Abhängigkeit vom Verdampfungsmaterial und / oder vom Abbrandzustand der Kathode und / oder ist in Abhängigkeit von einem anderen Betriebsparameter der Vakuum Lichtbogenverdampfungsquelle einstellbar und / oder steuerbar und / oder regelbar.
Je nach spezieller Anwendung kann die Magnetfeldstärke dabei durch eine Steuerung und / oder Regelung eines elektrischen Stroms durch einen Elektromagneten der ringförmigen Magnetfeldquelle und / oder des magnetischen Korrekturrings steuerbar und / oder regelbar sein.
Kommen Ringmagnete zum Einsatz, so kann die Magnetfeldstärke durch einen Austausch des Ringmagneten und / oder durch einen zusätzlichen Ringmagneten und / oder durch Entfernung eines Ringmagneten der ringförmigen Magnetfeldquelle und / oder des magnetischen Korrekturrings einstellbar sein.
Für viele praktische Anwendungen haben sich solche erfindungsgemässe Ausführungsbeispiele als besonders vorteilhaft erwiesen, bei welchen die Magnetfeldstärke durch eine Veränderung einer Anzahl der Mehrzahl von parallel zur Flächennormalen ausgerichteten Permanentmagneten der ringförmigen Magnetfeldquelle und / oder des Magnetfeldverstärkungsrings und / oder des magnetischen Korrekturrings einstellbar ist.
Was die magnetischen Polarisationsrichtungen der verschiedenen Magnetfeldquellen angeht, kann die ringförmige Magnetfeldquelle und / oder der Magnetfeldverstärkungsring und / oder der magnetische Korrekturring gleichartig in Bezug auf die Flächennormale polarisiert sein, oder in einem anderen Fall kann die ringförmige Magnetfeldquelle und / oder der Magnetfeldverstärkungsring und / oder der magnetische Korrekturring entgegengesetzt in Bezug auf die Flächennormale polarisiert sein.
Wie aus dem Stand der Technik an sich bekannt, ist zur Kühlung der Lichtbogenverdampfungsquelle bevorzugt ein Kühlsystem, insbesondere eine Wasserkühlung vorgesehen.
Insbesondere kann die ringförmige Magnetfeldquelle und / oder der Magnetfeldverstärkungsring und / oder der magnetische Korrekturring einen Hochtemperaturmagneten umfassen, insbesondere einen Hochtemperaturmagneten aus SmCo umfassen, so dass deutlich höhere Betriebstemperaturen mit einer Lichtbogenverdampfungsquelle erreichbar sind, bzw. mit einer reduzierten Kühlleistung an der Verdampferkathode gearbeitet werden kann. In speziellen Fällen kann sogar ganz auf eine Kühlung verzichtet werden.
Bevorzugt ist die ringförmige Magnetfeldquelle in an sich bekannter Weise an einem Trägerblock, insbesondere an einem Trägerblock aus Kupfer angeordnet und zur Begrenzung der Lichtbogenentladung auf die Verdampfungsoberfläche der Kathode ist zwischen dem Trägerblock und der Kathode eine BN-Isolierung vorgesehen.

Der Trägerblock kann dabei zur Zündung und Aufrechterhaltung der Lichtbogenentladung eine primäre Anode umfassen, wobei die primäre Anode elektrisch gegen den Trägerblock isoliert sein kann, jedoch in einem anderen Ausführungsbeispiel nicht zwingend elektrisch gegen den Trägerblock isoliert sein muss.

Zur Zündung und Aufrechterhaltung der Lichtbogenentladung kann die BN-Isolierung in berührendem Kontakt mit der Kathode stehen, eine Anordnung, die an sich aus dem Stand der Technik bekannt ist.

Um eine verbesserte Zündung des Lichtbogens zu erreichen kann die Lichtbogenverdampfungsquelle zur Zündung der Lichtbogenentladung eine schwenkbare Triggereinrichtung umfasst, die insbesondere linear bewegbar und / oder drehbar angeordnet ist.

Die Erfindung betrifft weiterhin eine Lichtbogenverdampfungskammer umfassend eine erfindungsgemässe Lichtbogenverdampfungsquelle, wie sie weiter oben und im folgenden anhand der Figuren ausführlich beschrieben ist.

Wie im Prinzip aus dem Stand der Technik bekannt ist, kann der Kathodenkörper einer erfindungsgemässen Vakuum
Lichtbogenverdampfungsquelle und die Lichtbogenverdampfungskammer selbst mit einer elektrischen Energieversorgungseinheit verbunden sein, wobei die Lichtbogenverdampfungskammer elektrisch als Anode in Bezug auf die Kathode geschaltet ist.

Auch kann die Lichtbogenverdampfungskammer in einer dem Fachmann an sich bekannten Weise über einen elektrischen Widerstand mit einer vom Trägerblock elektrisch isolierten primären Anode elektrisch verbunden sein oder eine vom Trägerblock elektrisch isolierte primären Anode ist mit einem positiven Pol einer elektrischen Hilfsversorgungseinheit verbunden, wobei die Lichtbogenverdampfungskammer mit einem negativen Pol der elektrischen Hilfsversorgungseinheit verbunden ist.

Die elektrische Energieversorgungseinheit und / oder die elektrische Hilfsversorgungseinheit kann dabei eine elektrische Gleichspannungs-Energiequelle sein, wobei in einem anderen Ausführungsbeispiel die elektrische Energieversorgungseinheit und / oder die elektrische Hilfsversorgungseinheit auch beispielweise eine gepulste elektrische Energiequelle oder jede andere geeignete elektrische Energiequelle sein kann.

Übliche Parameter zum Betreiben der erfindungsgemäßen Lichtbogenquelle im kontinuierlichem DC-Betrieb sind Betriebsspannungen der Energiequelle im Bereich von 10 - 600 V und Ströme im Bereich von 30 bis 500 A. Falls mit gepulsten Entladungen gearbeitet wird, können Pulsströme bis zu einigen 1000 A derart angelegt werden, so dass die Kühlung der Quelle noch ausreicht, um die zeitlich gemittelte Energie noch wegkühlen zu können. Die Pulsfrequenzen der Energiequelle können im Bereich von einigen Hz bis zu einigen 10 kHz liegen. Die Hilfsquelle wird bei ähnlichen Parametern betrieben.

Die Arbeitsdrücke bei denen die Verdampfer eingesetzt werden, reichen von Hochvakuum bis hin zu 50 Pa.

Die Erfindung wird im folgenden an Hand der schematischen Zeichnung näher erläutert. Es zeigen:
- Fig. 1: ein erstes Ausführungsbeispiel einer erfindungsgemässen Vakuum Lichtbogenverdampfungsquelle;
- Fig. 2a: eine Rückansicht einer Vakuum Lichtbogenverdampfungsquelle mit einer Mehrzahl von Permanentmagneten;
- Fig. 2b: ein Schnitt entlang der Schnittlinie I-I gemäss Fig. 2a;
- Fig. 3: ein erfindungsgemässes Ausführungsbeispiel einer Vakuum Lichtbogenverdampfungsquelle mit magnetischem Korrektorring;
- Fig. 4: eine Rückansicht eines anderen Ausführungsbeispiels gemäss Fig. 3 mit einer Mehrzahl von Permanentmagneten;
- Fig. 5: ein Ausführungsbeispiel mit BN-Isolierung;
- Fig. 6: eine Lichtbogenverdampfungskammer mit einer schwenkbaren Triggereinrichtung;
- Fig. 7: eine Lichtbogenverdampfungskammer mit isolierter primärer Anode und Widerstand;
- Fig. 8: ein Ausführungsbeispiel gemäss Fig. 8 mit Hilfsversorgungseinheit;
- Fig.9: eine erste Lichtbogenverdampfungskammer mit mehreren Lichtbogenverdampfungsquellen;
- Fig. 10: eine zweite Lichtbogenverdampfungskammer mit mehreren Lichtbogenverdampfungsquellen.

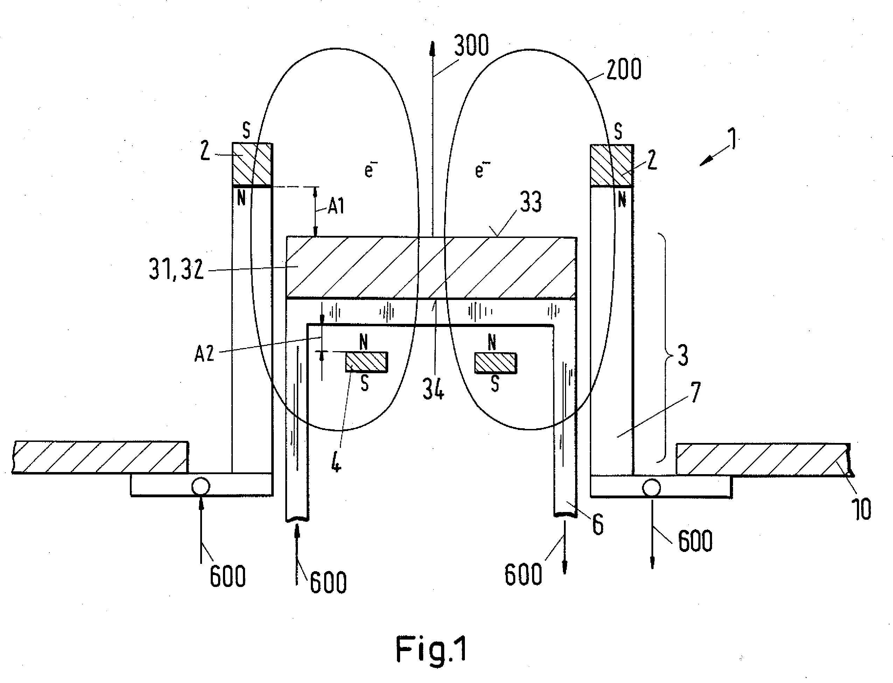

In Fig. 1 ist ein erstes einfaches Ausführungsbeispiel einer erfindungsgemässen Vakuum Lichtbogenverdampfungsquelle, die im folgenden gesamthaft mit dem Bezugszeichen 1 bezeichnet wird, im Einbauzustand in einer erfindungsgemässen Lichtbogenverdampfungskammer schematisch im Schnitt dargestellt.
Die erfindunsgemässe Vakuum Lichtbogenverdampfungsquelle 1, umfasst eine ringförmige Magnetfeldquelle 2 und einen Kathodenkörper 3 mit einem Verdampfungsmaterial 31 als Kathode 32 zur Erzeugung einer Lichtbogenentladung auf einer Verdampfungsoberfläche 33 der Kathode 32. Der Kathodenkörper 3 ist in einer ersten axialen Richtung von einem Kathodenboden 34 und in einer zweiten axialen Richtung von der Verdampfungsoberfläche 33 in axialer Richtung begrenzt. Die ringförmige Magnetfeldquelle 2 ist parallel bzw. antiparallel zu einer Flächenormalen 300 der Verdampfungsoberfläche 33 polarisiert und konzentrisch zu der Flächennormalen 300 der Verdampfungsoberfläche 33 in einem vorgebbaren ersten Abstand A1 auf einer vom Kathodenboden 34 abgewandten Seite vom Kathodenkörper 3 beabstandet. Gemäss der vorliegenden Erfindung ist ein Magnetfeldverstärkungsring 4 auf einer der Verdampfungsoberfläche 33 abgewandten Seite in einem vorgebbaren zweiten Abstand A2 vor dem Kathodenboden 34 angeordnet. Erfindungsgemäß umfasst der Magnetfeldverstärkungsring eine Mehrzahl von im Wesentlichen parallel zur Flächennormalen ausgerichteten Permanentmagneten.

Ein Innendurchmesser DI des Magnetfeldverstärkungsrings 4 beträgt dabei ca. 3%, insbesondere bis 10%, bevorzugt bis 15%, im Speziellen bis zu 50% oder mehr als 50 % eines Durchmessers der Kathode 32. Wird also z.B. eine Kathode 32 mit einem Durchmesser von 100 mm verwendet, so beträgt der Innendurchmesser DI des Magnetverstärkungsrings 4 z.B. 3 mm, insbesondere bis zu 10 mm, bevorzugt bis 15 mm und im Speziellen bis zu 50 mm oder mehr.
Eine Breite B des Magnetfeldverstärkungsrings 4 kann ca. 2%, insbesondere bis 5%, bevorzugt bis 10% oder mehr als 10 %eines Durchmessers der Kathode 32 betragen. Wird wiederum von einer Kathode 32 mit einem Durchmesser von 100 mm ausgegangen, kann also die Breite B des Magnetverstärkungsrings 4 z.B. 2 mm, insbesondere bis zu 5 mm und bevorzugt bis zu 10 mm oder mehr betragen
Die konkrete Geometrie des Magnetverstärkungsrings 4 kann dabei von den speziellen Anforderungen an die konkrete Beschichtungsaufgabe, die Geometrie und / oder Grösse der Beschichtungsanordnungen, dem Kathodenmaterial oder von andere, den Beschichtungsprozess beeinflussenden Grössen abhängen.

Die Vakuum Lichtbogenverdampfungsquelle ist dabei in an sich bekannter Weise in einer Lichtbogenverdampfungskammer 10 eingebaut und zur Kühlung mit einem Kühlsystem 6 versehen, das ,wie durch die Pfeile 600 angedeutet, zur Kühlung von Kühlwasser 600 durchströmt wird. Das durch die ringförmige Magnetfeldquelle 2 und den Magnetverstärkungsring 4 gesamthaft erzeugte magnetische Feld ist in stark vereinfachter schematischer Darstellung durch die Magnetfeldlinien 200 symbolisiert, die nicht die tatsächliche Geometrie des Magnetfeldes wiedergeben und die z.B. die Bewegung der Elektronen e⁻ beeinflussen.

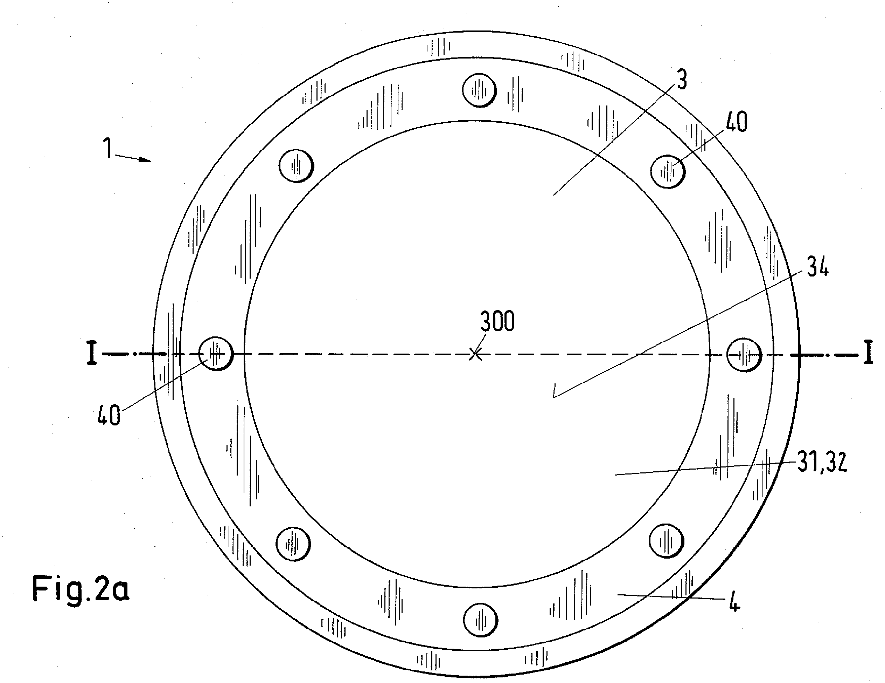

In Fig. 2a ist eine Rückansicht, das heisst eine Aufsicht auf den Kathodenboden 34 einer Vakuum Lichtbogenverdampfungsquelle 1 dargestellt, bei welcher der Magnetverstärkungsring 4 im wesentlichen durch eine Mehrzahl von Permanentmagneten 40 gebildet ist. Die Permanentmagnete 40 des Magnetfeldverstärkungsrings 4 sind dabei auf der der Verdampfungsoberfläche 33 abgewandten Seite in einem vorgebbaren zweiten Abstand A2 vor dem Kathodenboden 34 angeordnet und im wesentlichen in Bezug auf ihre magnetische Polarisation parallel bzw. antiparallel zur Flächenormalen 300 ausgerichtet. Es versteht sich, dass z.B. alle Permanentmagneten 40 entweder parallel oder antiparallel in Bezug auf die Flächen 300 ausgerichtet sein können, oder dass ein Teil der Permanentmagnete 40 parallel und ein anderer Teil der Permanentmagnete 40 antiparallel in Bezug auf die Flächennormale 300 ausgerichtet sein kann, z.B. um besondere Magnetfeldgeometrien im Bereich des Kathodenkörpers 3 zu realisieren.

Es versteht sich darüber hinaus, dass sowohl der Magnetfeldverstärkungsring 4, und / oder der magnetische Korrekturring 5 und / oder die Magnetfeldquelle 2 z.B. durch einen ferritischen oder einen ferromagnetischen oder einen nichtmagnetischen Ring gebildet sein können, auf dem z.B. die Mehrzahl von parallel zur Flächennormalen 300 ausgerichteten Permanentmagneten (20, 40,50) angeordnet sind, wobei klar ist, das der ferritische oder der ferromagnetische oder nicht-magnetische Ring auch fehlen kann.

In einem für die Praxis wichtigen Ausführungsbeispiel ist z.B. der Magnetverstärkungsring 4 durch einen ferritischen Ring gebildet, auf dem im Abstand von 120° drei Permanentmagnete 40 angeordnet sind.

Das zuvor gesagt trifft selbstverständlich auch auf mögliche Anordnungen der Permanentmagnete 20 der ringförmigen Magnetfeldquelle 2 und auf die Permanentmagnete 50 des magnetische Korrekturrings 5 zu, die weiter unten noch detaillierter beschrieben werden.

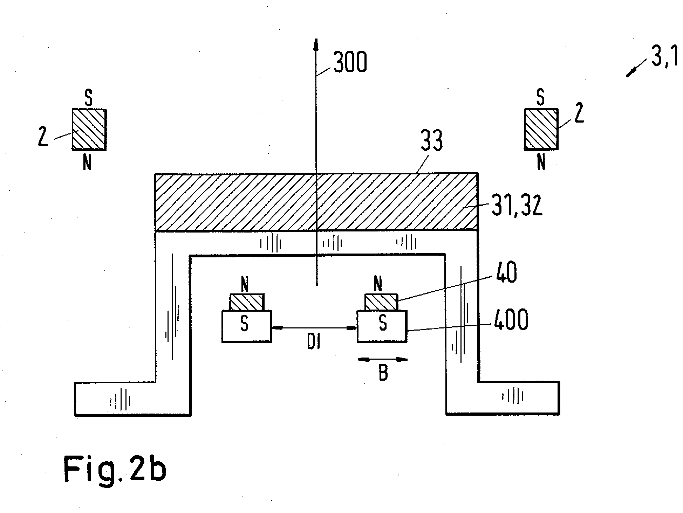

Zur Verdeutlichung ist in Fig. 2b ein Schnitt entlang der Schnittlinie I-I durch den Kathodenkörper 3 gemäss Fig. 2a dargestellt. Zu sehen ist die ringförmige Magnetfeldquelle 2, die direkt oberhalb der Verdampfungsoberfläche 33 konzentrisch zur Flächenormalen 3 angeordnet ist. Im Beispiel der Fig. 2b ist die ringförmige Magnetfeldquelle 2 ein Ringmagnet 2. Es versteht, dass in einem anderen Ausführungsbeispiel der Ringmagnet 2 auch aus mehreren einzelnen Ringmagneten 2 gebildet sein kann und / oder durch eine Mehrzahl von Permanentmagneten 20 gebildet sein kann und / oder durch einen Elektromagneten 2 realisiert werden kann.

Der Magnetfeldverstärkungsring 4 umfasst einen magnetischen oder nicht magnetischen Trägerring 400, in welchem die Permanentmagnete 40 bevorzugt lösbar vorgesehen sind, so dass diese bequem ausgetauscht werden, bzw. je nach Anforderung die Gesamtzahl der Permanentmagnete 40 variiert werden kann, so dass die Stärke und / oder die Geometrie des durch den Magnetfeldverstärkungsring 4 verursachten Magnetfeldes sehr einfach variierbar ist.

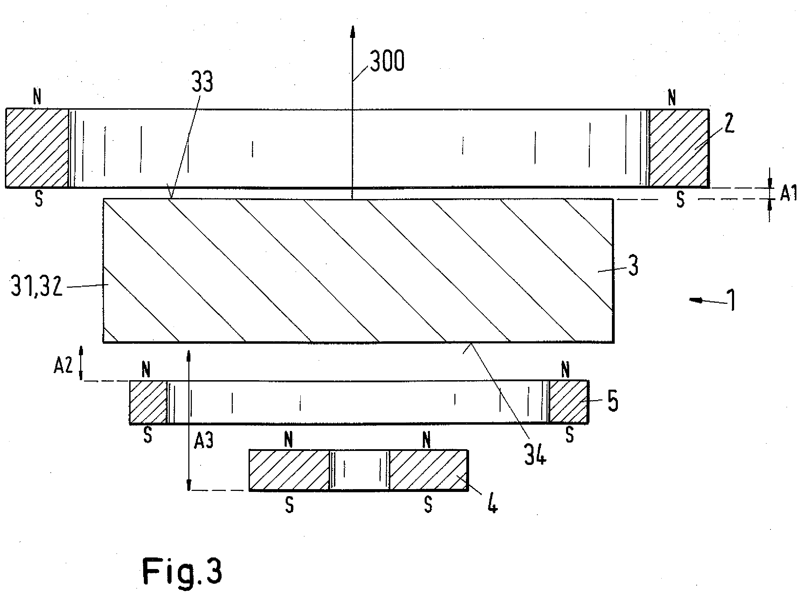

In Fig. 3 ist ein weiteres, für die Praxis besonders wichtiges erfindungsgemässes Ausführungsbeispiel einer Vakuum Lichtbogenverdampfungsquelle 1 mit einem magnetischem Korrektorring 5 teilweise im Schnitt dargestellt. Die ringförmige Magnetfeldquelle 2 ist in einem Abstand A1 von der Verdampfungsoberfläche 33 der Katode 3 beabstandet. Der magnetische Korrekturring 5 ist in einem Abstand A2 etwas näher zum Kathodenboden 34 platziert, als der Magnetverstärkungsring 4, der in einem etwas grösseren Abstand A3 vom Kathodenboden 34 beabstandet ist. Dabei sind nicht näher dargestellte, dem Fachmann an sich bekannte Mittel vorhanden, die es gestatten, je nach Anforderung die Abstände A1, A2 und A3 in geeigneter Weise zu verändern.

Im Beispiel der Fig. 3 sind die Magnetfeldquelle 2, der Magnetfeldverstärkungsring 4 und der magnetische Korrekturring 5 in Bezug auf die Flächennormale 300 gleichsinnig magnetisch polarisiert. Es versteht sich, dass die vorgenannten magnetischen Ringe in anderen Ausführungsbeispielen auch in jeder anderen geeigneten Kombination in Bezug auf die Flächennormale 300 angeordnet sein können. Das kann je nach Anforderungen variieren und z.B. durch die relative Stärke der verwendeten Magnete 2, 4, 5 bestimmt sein und / oder die spezielle geometrische Anordnung in Bezug auf den Kathodenkörper 3 oder durch andere apparative oder verfahrenstechnische Vorgaben bestimmt sein.

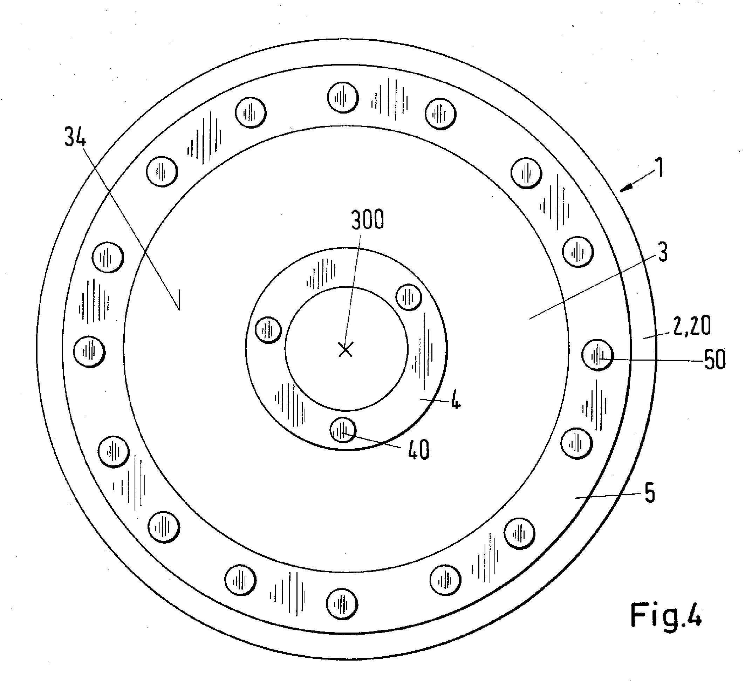

Fig. 4 zeigt eine Rückansicht eines anderen Ausführungsbeispiels gemäss Fig. 3, bei welchem der Magnetverstärkungsring 4 und der magnetische Korrekturring 5 durch eine Mehrzahl von Permanentmagneten 40, 50 gebildet ist. Bei dem Beispiel der Fig. 4 haben der Magnetverstärkungsring 4 und der magnetische Korrekturring 5 den gleichen Abstand zum Kathodenboden 34.

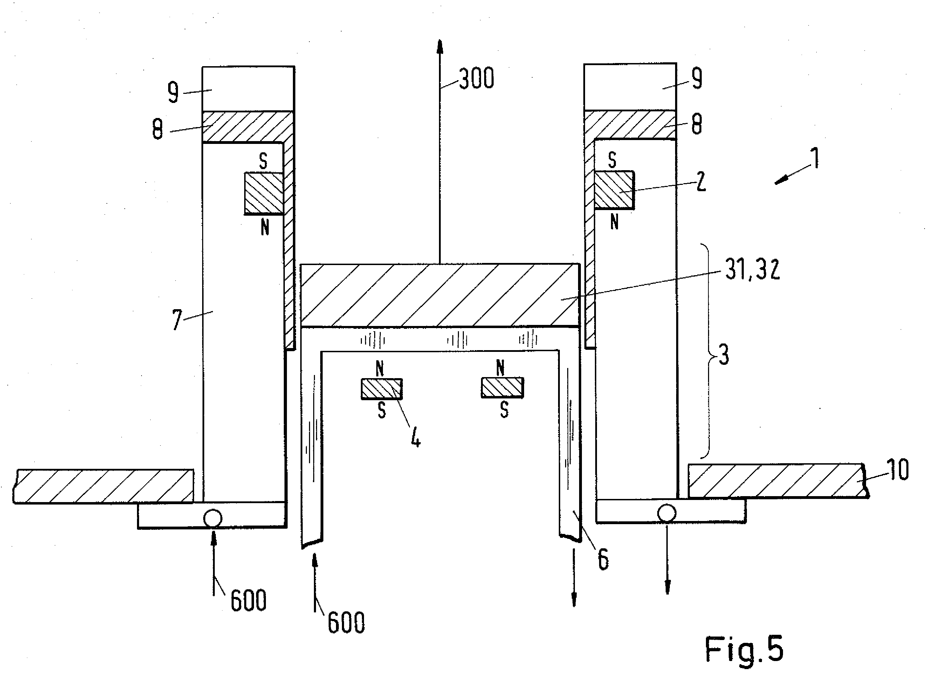

In Fig. 5 ist schematisch ein Ausführungsbeispiel dargestellt, wobei die Anode 9 über eine BN-Isolierung, also über eine elektrisch isolierende Schicht, die als wesentlichen Bestandteil Bornitrid, also BN, enthält, gegen einen elektrisch leitenden Trägerblock 7, der zum Beispiel aus Kupfer bestehen kann, elektrisch isoliert. Diese Anordnung mit BN-Schicht ist ans ich bekannt und dient vor allem dazu, im Betriebszustand ein Übersprechen des Lichtbogens auf die Anode 9 bzw. den Trägerblock 7 zu verhindern. Die Anode 9 kann dabei zur Zündung und Aufrechterhaltung des Lichtbogens während eines Beschichtungsvorgangs dienen.

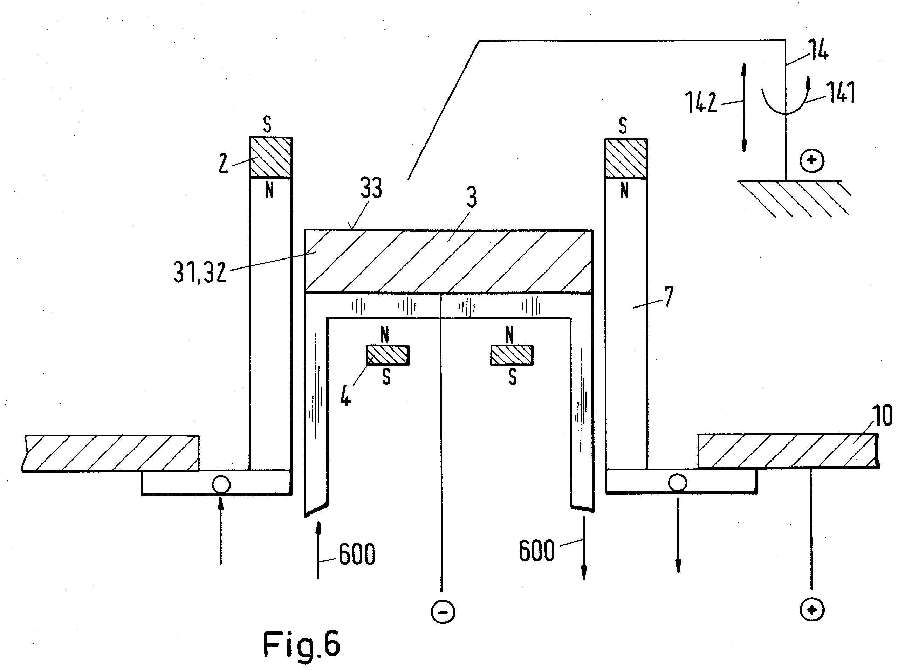

Bei dem Ausführungsbeispiel der Fig. 6 ist eine Lichtbogenverdampfungskammer 10 mit einer schwenkbaren Triggereinrichtung 14 schematisch dargestellt, wobei die Triggereinrichtung 14 auf einem positiven Potential elektrisch als Anode gegen die auf einem negativen elektrischen Potential liegenden Kathodenkörper 3 geschaltet ist. Die Triggereinrichtung 14 dient in an sich bekannter Weise zur Zündung und Aufrechterhaltung eines Lichtbogens, und ist, wie durch den Pfeil 141 dargestellt, um eine Drehachse sowohl schwenkbar, als auch entlang dem Pfeil 142 linear im Abstand zur Verdampfungsoberfläche 33 veränderbar.

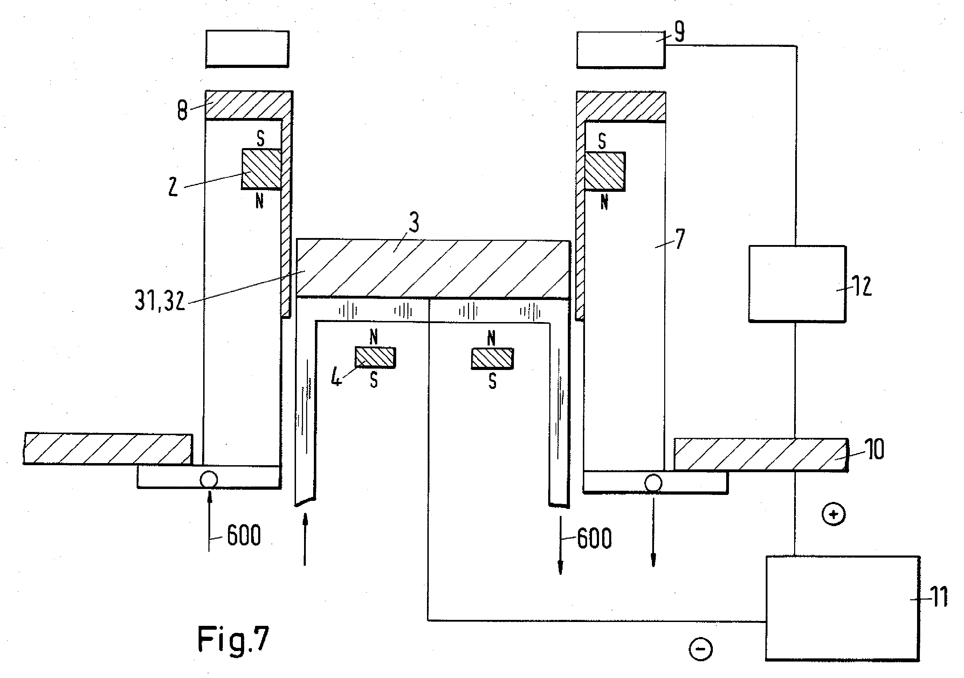

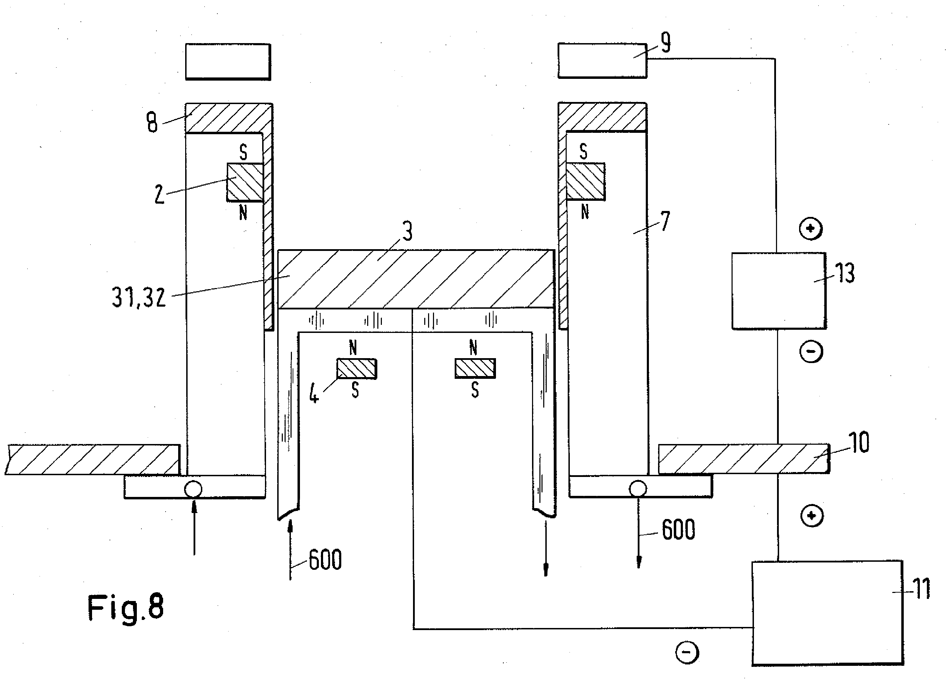

Die Fig. 7 und Fig. 8 zeigen jeweils ein Ausführungsbeispiel einer erfindungsgemässen Lichtbogenverdampfungskammer mit isolierter primärer Anode. Die Lichtbogenverdampfungskammer 10 ist in beiden Beispielen mit einem positiven Pol einer Energieversorgungseinheit 11 verbunden und der Kathodenkörper 3 mit einem negativen Pol der Energieversorgungseinheit 11 verbunden. D.h., die Lichtbogenverdampfungskammer 10 ist elektrisch als Anode in Bezug auf den Kathodenkörper 3 geschaltet.

Die Anode 9 ist jeweils als vom Trägerblock 7 elektrisch isolierte primäre Anode 9 ausgeführt. Dabei ist im Beispiel der Fig. 7 die primäre Anode 9 über einen elektrischen Widerstand 12 mit der Lichtbogenverdampfungskammer 10 elektrisch gekoppelt, während im Beispiel der Fig. 8 die primäre Anode 9 über eine Hilfsversorgungseinheit 13 in der an sich bekannten dargestellten Weise mit der Lichtbogenverdampfungskammer 10 gekoppelt ist.

Für diese Art der elektrischen Anordnung von Trägerblock 7, Energieversorgungseinheit 11 und primärer Anode 9 ist es wesentlich, dass eine Potentialtrennung zwischen Lichtbogenverdampfungskammer 10 und Anode 9 hergestellt wird, so dass eine primäre Anode 9 und eine sekundäre Anode geschaffen werden, wobei die sekundäre Anode durch die Lichtbogenverdampfungskammer 10 selbst gebildet wird.

Es versteht sich, dass eine Potentialtrennung zwischen primärere Anode 9 und Lichtbogenverdampfungskammer 10 auch dadurch realisiert werden kann, dass die Hilfsversorgungseinheit 13 bzw. der elektrische Widerstand 12 zwischen dem Trägerblock 7 und der Lichtbogenverdampfungskammer 12 angeordnet sind, wobei die primäre Anode 9 dann mit dem Trägerblock 7 in elektrischer Verbindung steht, bzw. der Trägerblock 7 die primäre Anode 9 bildet oder unmittelbar umfasst.

Dabei sind die theoretischen und praktischen Grundlagen zur elektrischen Verschaltung zwischen Lichtverdampfungskammer 10 und Vakuumlichtverdampfungsquelle 9 dem Fachmann an sich bekannt und brauchen daher an dieser Stelle nicht weiter im Detail beschrieben zu werden.

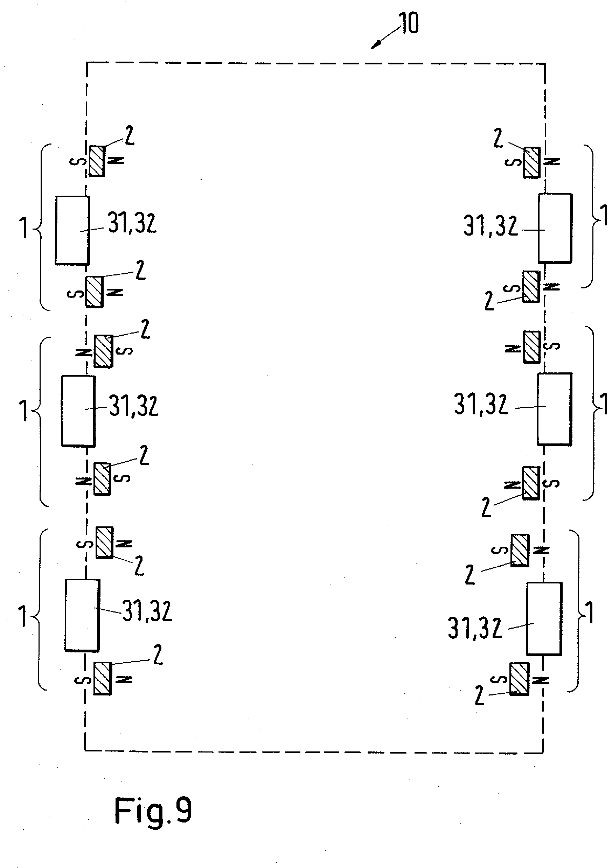

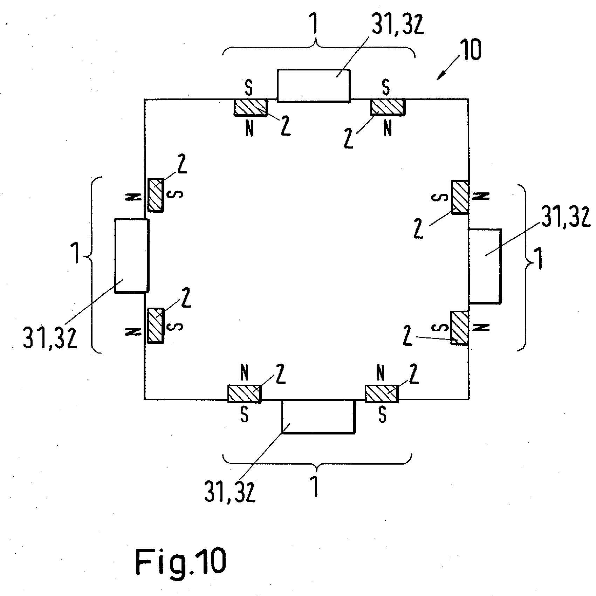

In den Fig. 9 und Fig. 10 sind exemplarisch noch zwei spezielle Ausführungsbeispiele erfindungsgemässer Lichtbogenverdampfungskammern 10 dargestellt, die für die Praxis von besonderer Bedeutung sind. Es wird dabei insbesondere die Anordnung der Polaritäten einzelner Verdampfer für den Fall exemplarisch beschrieben, wenn mehrere Verdampfer in die Lichtbogenverdampfungskammer 10 eingebaut sind.

Anhand der Fig. 9 und Fig. 10 kann dabei besonders anschaulich die Wechselwirkung zwischen den magnetischen Feldlinien beim Vorhandensein mehrerer Lichtbogenverdampfungsquellen 1 in ein und derselben Lichtbogenverdampfungskammer 10 demonstriert werden. Je nach Anforderungen an eine konkrete Beschichtungsaufgabe, kann z.B. die Variante gemäss Fig. 9 oder gemäss Fig. 10 besser geeignet sein. Es versteht sich, dass natürlich auch andere Anordnungen von erfindungsgemässen Lichtbogenverdampfungsquellen 1 in einer Lichtbogenverdampfungskammer 10 von der Erfindung erfasst sind.

Bild 9 zeigt eine Anordnung mit einer ersten Lichtbogenverdampfungskammer 10 mit mehreren Lichtbogenverdampfungsquellen 1, die zu einer Feldverstärkung gegenüberliegender Lichtbogenverdampfungsquellen 1 quer durch die Lichtbogenverdampfungskammer 10 führt. Vorzugsweise werden darstellungsgemäss untereinander liegende Lichtbogenverdampfungsquellen 1 wechselseitig hinsichtlich ihrer Polarität angeordnet. Durch die Anordnung der Magnetfeldfeldquellen 2 mit wechselnder Polarität (z.B. der N-Pol liegt dem S-Pol gegenüber), werden Magnetfeldlinien quer durch die Lichtbogenverdampfungskammer 10 geschlossen. Dies führt zu einer günstigen Beeinflussung der Anregung von Reaktivgasen in der Nähe der zu beschichtenden Substrate, die aus Gründen der Übersichtlichkeit in den Fig. 9 und 10 nicht dargestellt sind. Durch die Anordnung der Fig. 9 wird die Anregung von Reaktivgasen in der Nähe der zu beschichtenden Substrate Schichtwachstum positiv beeinflusst.

Eine weitere Variante einer Lichtbogenverdampfungskammer 10 mit mehreren Lichtbogenverdampfungsquellen 1 zeigt Bild 10. Hierbei befinden sich die Verdampfer 1 in einer Ebene rund um die Kammer 10. Diese Wechselseitige Anordnung bewirkt, dass eine Feldverstärkung gemäss Fig. 9 quer durch die Kammer 10 nicht auftritt, sondern ein geschlossenes Magnetfeld zwischen den Verdampfern1 entsteht. Dieser Aufbau ist dann zu bevorzugen, wenn eine zusätzliche Anregung der Reaktivität der Prozessgase in der Nähe der Substrate unerwünscht ist, z.B. dann, wenn Schichten abgeschieden werden sollen, bei denen ein geringer Anteil von Reaktivgasen in den Schichten erwünscht ist.

Es versteht sich, dass die beschriebenen Ausführungsbeispiele lediglich exemplarisch zu verstehen sind und sich der Schutzbereich nicht auf die explizit beschriebenen Ausführungsformen beschränkt. Insbesondere ist jede geeignete Kombination von Ausführungsbeispielen ebenfalls durch die Erfindung umfasst.

Dabei kann eine erfindungsgemässe Lichtbogenverdampfungsquelle vielseitig zum Beschichten verschiedenster Werkstücke eingesetzt werden. Unter Verwendung der üblichen Reaktivgase z.B. zur Herstellung von nitridischen, carbidischen, carbonitridischen oder oxynitridischen Schichten, sowie zur Herstellung von Oxydschichten oder carbo-oxynitridischer Schichten oder aller anderen Schichten, die vorteilhaft mit einer Lichtbogenverdampfungsquelle herstellbar sind.

Nachfolgend werden einige praktische Methoden der Einstellung der Magnetfelder je nach Verdampfungsaufgabe aufgezeigt.

Die ringförmige Magnetfeldquelle ermöglicht durch die massive Konstruktion der Trägerplatte mit Bohrungen zur Magazinierung eine Auswahl der Anzahl der Magnete sowie der Festlegung deren relativer Position A1. Eine Anode wird dann gegebenenfalls auf die Bohrungslöcher aufgeschraubt.

Der Magnetfeldverstärkungsring sowie der Korrekturring lassen sich einfach austauschen, da der Bauraum hinter dem Kathodenboden frei gestaltet ist.

Die Ringe selber bestehen bevorzugt aus Einzelmagneten, so dass deren Anzahl und Polarität einstellbar sind. Eine Einstellung der Abstände zum Kathodenboden bzw. untereinander lässt sich mit einfachen mechanischen Schiebe- und Klemmsystemen realisieren.

## Patentansprüche

1. Vakuum Lichtbogenverdampfungsquelle, umfassend eine ringförmige Magnetfeldquelle (2) und einen Kathodenkörper (3) mit einem Verdampfungsmaterial (31) als Kathode (32) zur Erzeugung einer Lichtbogenentladung auf einer Verdampfungsoberfläche (33) der Kathode (32), wobei der Kathodenkörper (3) in einer ersten axialen Richtung von einem Kathodenboden (34) und in einer zweiten axialen Richtung von der Verdampfungsoberfläche (33) in axialer Richtung begrenzt ist, und die ringförmige Magnetfeldquelle (2) parallel oder antiparallel zu einer Flächennormalen (300) der Verdampfungsoberfläche (33) polarisiert und konzentrisch zu der Flächennormalen (300) der Verdampfungsoberfläche (33) angeordnet ist, wobei ein Magnetfeldverstärkungsring (4) auf einer der Verdampfungsoberfläche (33) abgewandten Seite in einem vorgebbaren zweiten Abstand (A2) vor dem Kathodenboden (34) angeordnet ist, und mindestens ein magnetischer Korrekturring (5) auf der der Verdampfungsoberfläche (33) abgewandten Seite in einem vorgebbaren dritten Abstand (A3) vor dem Kathodenboden (34) angeordnet ist, **dadurch gekennzeichnet, dass**, der Magnetfeldverstärkungsring (4) eine Mehrzahl von im Wesentlichen parallel zur Flächennormalen (300) ausgerichteten Permanentmagneten (20, 40, 50) umfasst.

2. Vakuum Lichtbogenverdampfungsquelle nach Anspruch 1, wobei die Magnetfeldquelle (2) derart konzentrisch zu der Flächennormalen (300) der Verdampfungsoberfläche (33) angeordnet ist, dass die Verdampfungsoberfläche (33) zwischen einem Nordpol und einem Südpol der Magnetfeldquelle (2) liegt.

3. Vakuum Lichtbogenverdampfungsquelle nach Anspruch 1, wobei die Magnetfeldquelle (2) in einem vorgebbaren ersten Abstand (A1) auf einer vom Kathodenboden (34) abgewandten Seite des Kathodenkörpers (3) von der Verdampfungsoberfläche (33) beabstandet ist.

4. Vakuum Lichtbogenverdampfungsquelle nach einem der vorangehenden Ansprüche, wobei der Magnetfeldverstärkungsring (4) oder der magnetische Korrekturring (5) parallel oder antiparallel zur Flächennormalen (300) polarisiert oder konzentrisch zur Flächennormalen (300) angeordnet ist.

5. Vakuum Lichtbogenverdampfungsquelle nach einem der vorangehenden Ansprüche, wobei der Magnetfeldverstärkungsring (4) oder der magnetische Korrekturring (5) nicht-konzentrisch zur Flächennormalen (300) ausgerichtet ist oder der Magnetfeldverstärkungsring (4) oder der magnetische Korrekturring (5) eine nicht-kreisförmige Querschnittsfläche hat.

6. Vakuum Lichtbogenverdampfungsquelle nach einem der vorangehenden Ansprüche, wobei der erste Abstand (A1) oder der zweite Abstand (A2) oder der dritte Abstand (A3) in einem Bereich von null bis 200mm liegt.

7. Vakuum Lichtbogenverdampfungsquelle nach einem der vorangehenden Ansprüche, wobei die ringförmige Magnetfeldquelle (2) oder der magnetische Korrekturring (5) eine Mehrzahl von parallel zur Flächennormalen (300) ausgerichteten Permanentmagneten (20, 40, 50) umfasst.

8. Vakuum Lichtbogenverdampfungsquelle nach einem der vorangehenden Ansprüche, wobei die ringförmige Magnetfeldquelle (2) oder der magnetische Korrekturring (5) einen Ringmagneten umfasst.

9. Vakuum Lichtbogenverdampfungsquelle nach einem der vorangehenden Ansprüche, wobei die ringförmige Magnetfeldquelle (2) oder der magnetische Korrekturring (5) einen Elektromagneten umfasst.

10. Vakuum Lichtbogenverdampfungsquelle nach einem der vorangehenden Ansprüche, wobei eine Magnetfeldstärke der ringförmigen Magnetfeldquelle (2) oder eine Magnetfeldstärke des magnetischen Korrekturrings (5) veränderbar oder steuerbar oder regelbar ist, insbesondere in Abhängigkeit vom Verdampfungsmaterial (31) oder vom Abbrandzustand der Kathode (32) oder in Abhängigkeit von einem anderen Betriebsparameter der Vakuum Lichtbogenverdampfungsquelle steuerbar oder regelbar ist.

11. Vakuum Lichtbogenverdampfungsquelle nach einem der vorangehenden Ansprüche, wobei die ringförmige Magnetfeldquelle (2) oder der Magnetfeldverstärkungsring (4) oder der magnetische Korrekturring (5) gleichartig in Bezug auf die Flächennormale (300) polarisiert sind.

12. Vakuum Lichtbogenverdampfungsquelle nach einem der vorangehenden Ansprüche, wobei die ringförmige Magnetfeldquelle (2) oder der Magnetfeldverstärkungsring (4) oder der magnetische Korrekturring (5) entgegengesetzt in Bezug auf die Flächennormale (300) polarisiert sind.

13. Vakuum Lichtbogenverdampfungsquelle nach einem der vorangehenden Ansprüche, wobei die ringförmige Magnetfeldquelle (2) oder der Magnetfeldverstärkungsring (4) oder der magnetische Korrekturring (5) einen Hochtemperaturmagneten umfasst, insbesondere einen Hochtemperaturmagneten aus SmCo.

14. Vakuum Lichtbogenverdampfungsquelle nach einem der vorangehenden Ansprüche, wobei die ringförmige Magnetfeldquelle (2) an einem Trägerblock (7) angeordnet ist und zur Begrenzung der Lichtbogenentladung auf die Verdampfungsoberfläche (33) der Kathode (32) zwischen dem Trägerblock (7) und der Kathode (32) eine BN-Isolierung (8) vorgesehen ist, wobei der Trägerblock (7) insbesondere aus Kupfer ausgeführt ist.

15. Lichtbogenverdampfungskammer umfassend eine Vakuum Lichtbogenverdampfungsquelle (1) nach einem der Ansprüche 1 bis 14.

## Claims

1. A vacuum arc vaporisation source, including a ring-like magnetic field source (2) and a cathode body (3) with an vaporisation material (31) as a cathode (32) for the production of an arc discharge on an vaporisation surface (33) of the cathode (32), wherein the cathode body (3) is bounded in the axial direction, in a first axial direction by a cathode base (34) and in a second axial direction by the vaporisation surface (33) and wherein the ring-like magnetic field source (2) is arranged polarised parallel to or anti-parallel to a surface normal (300) and concentric to a surface normal (300) of the vaporisation surface (33), wherein a magnetic field enhancement ring (4) is arranged on a side remote from the vaporisation surface (33) at a pre-determinable second spacing (A2) in front of the cathode base (34), and
at least one magnetic correction ring (5) is arranged on the side remote from the vaporisation surface (33) at a pre-determinable third distance (A3) in front of the cathode base (34)
**characterised in that**
the magnetic field enhancement ring (4) includes a plurality of permanent magnets (20, 40, 50) aligned parallel to the surface normal (300).

2. A vacuum arc vaporisation source in accordance with claim 1 wherein the magnetic field source (2) is arranged concentric to the surface normal (300) of the vaporisation surface (33) in such a way that the vaporisation surface (33) lies between a north pole and a south pole of the magnetic field source (2).

3. A vacuum arc vaporisation source in accordance with claim 1, wherein the magnetic field source (2) is spaced from the vaporisation surface (33) at a pre-determinable first distance (A1) on a side of the cathode body (3) remote from the cathode base (34).

4. A vacuum arc vaporisation source in accordance with any one of the previous claims wherein the magnetic field enhancement ring (4) or the magnetic correction ring (5) is arranged polarised parallel to or anti-parallel to the surface normal (300) or concentric to the surface normal (300).

5. A vacuum arc vaporisation source in accordance with any one of the previous claims wherein the magnetic field enhancement ring (4) or the magnetic correction ring (5) is aligned not concentric to the surface normal (300) or the magnetic field enhancement ring (4) or the magnetic correction ring (5) has a non-circular cross-sectional area.

6. A vacuum arc vaporisation source in accordance with any one of the previous claims wherein the first spacing (A1) or the second spacing (A2) or the third spacing (A3) lies in a range from zero to 200mm.

7. A vacuum arc vaporisation source in accordance with any one of the previous claims wherein the ring-like magnetic field source (2) or the magnetic correction ring (5) includes a plurality of permanent magnets (20, 40, 50) aligned parallel to the surface normal (300).

8. A vacuum arc vaporisation source in accordance with any one of the previous claims wherein the ring-like magnetic field source (2) or the magnetic correction ring (5) includes a ring magnet.

9. A vacuum arc vaporisation source in accordance with any one of the previous claims wherein the ring-like magnetic field source (2) or the magnetic correction ring (5) includes an electromagnet.

10. A vacuum arc vaporisation source in accordance with any one of the previous claims wherein a magnetic field strength of the ring-like magnetic field source (2) or a magnetic field strength of the magnetic correction ring (5) can be altered or controlled or regulated, in particular in dependence on the vaporisation material (31) or on the state of erosion of the cathode (32) or can be controlled or regulated in dependence on another operating parameter of the vacuum arc vaporisation source.

11. A vacuum arc vaporisation source in accordance with any one of the previous claims, wherein the ring-like magnetic field source (2) or the magnetic field enhancement ring (4) or the magnetic correction ring (5) are polarised in the same direction in relation to the surface normal (300).

12. A vacuum arc vaporisation source in accordance with any one of the previous claims, wherein the ring-like magnetic field source (2) or the magnetic field enhancement ring (4) or the magnetic correction ring (5) are polarised in opposition in relation to the surface normal (300).

13. A vacuum arc vaporisation source in accordance with any one of the previous claims, wherein the ring-like magnetic field source (2) or the magnetic field enhancement ring (4) or the magnetic correction ring (5) includes a high temperature magnet, in particular a high temperature magnet made of SmCo.

14. A vacuum arc vaporisation source in accordance with any one of the previous claims, wherein the ring-like magnetic field source (2) is arranged on a mounting block (7) and a BN insulation is provided between the mounting bock (7) and the cathode (32) for the restriction of the arc discharge on the vaporisation surface (33) of the cathode (32), wherein the mounting block (7) is in particular made of copper.

15. An arc vaporisation chamber including a vacuum arc vaporisation source (1) in accordance with any one of the claims 1 to 14.

## Revendications

1. Source d'évaporation par arc sous vide, comprenant une source de champ magnétique annulaire (2) et un corps de cathode (3) avec un matériau d'évaporation (31) en tant que cathode (32) pour la génération d'une décharge en arc sur une surface d'évaporation (33) de la cathode (32), dans lequel le corps de cathode (3) est limitée dans la direction axiale dans une première direction axiale d'un fond de cathode (34) et dans une deuxième direction axiale de la surface d'évaporation (33), et la source de champ magnétique annulaire (2) est polarisée parallèlement ou antiparallèlement à une normale à la surface (300) de la surface d'évaporation (33) et disposée concentrique à la normale à la surface (300) de la surface d'évaporation (33), dans lequel un anneau de champs magnétique de renforcement (4) est disposé sur un côté détourné de la surface d'évaporation (33) dans une deuxième distance (A2) prédéterminable devant le fond de cathode (34), et au moins un anneau magnétique de correction (5) est disposé sur le côté détourné de la surface d'évaporation (33) dans une troisième distance (A3) prédéterminable devant le fond de cathode (34), **caractérisé en ce que**, l' anneau de champs magnétique de renforcement (4) comprend une pluralité d'aimants permanents (20, 40, 50), essentiellement orientés parallèlement à la normale à la surface (300).

2. Source d'évaporation par arc sous vide selon la revendication 1, dans lequel la source de champ magnétique (2) est disposée de façon concentrique à une normale à la surface (300) de la surface d'évaporation (33), que la surface d'évaporation (33) est entre un pôle nord et un pôle sud de la source de champ magnétique (2).

3. Source d'évaporation par arc sous vide selon la revendication 1, dans lequel la source de champ magnétique (2) est espacée dans une première distance (A1) prédéterminable sur un côté du corps de cathode (3) détourné du fond de cathode (34).

4. Source d'évaporation par arc sous vide selon l'une des revendications précédentes, dans lequel l'anneau de champs magnétique de renforcement (4) ou l'anneau magnétique de correction (5) est polarisé parallèlement ou antiparallèlement à la normale à la surface (300) ou disposée concentrique à la normale à la surface (300).

5. Source d'évaporation par arc sous vide selon l'une des revendications précédentes, dans lequel l'anneau de champs magnétique de renforcement (4) ou l'anneau magnétique de correction (5) est orienté non- concentrique à la normale à la surface (300) ou l'anneau de champs magnétique de renforcement (4) ou l'anneau magnétique de correction (5) a une surface de section transversale non-annulaire.

6. Source d'évaporation par arc sous vide selon l'une des revendications précédentes, dans lequel la première distance (A1) ou la deuxième distance (A2) ou la troisième distance (A3) est entre de zéro à 200 mm.

7. Source d'évaporation par arc sous vide selon l'une des revendications précédentes, dans lequel la source de champ magnétique annulaire (2) ou l'anneau magnétique de correction (5) comprend une pluralité d'aimants permanents (20, 40, 50), orientés parallèlement à la normale à la surface (300).

8. Source d'évaporation par arc sous vide selon l'une des revendications précédentes, dans lequel la source de champ magnétique annulaire (2) ou l'anneau magnétique de correction (5) comprend un aimant annulaire.

9. Source d'évaporation par arc sous vide selon l'une des revendications précédentes, dans lequel la source de champ magnétique annulaire (2) ou l'anneau magnétique de correction (5) comprend un électro-aimant.

10. Source d'évaporation par arc sous vide selon l'une des revendications précédentes, dans lequel une intensité de champ magnétique de la source de champ magnétique annulaire (2) ou une intensité de champ magnétique de l'anneau magnétique de correction (5) est modifiable ou commandable ou réglable, en particulier commandable ou réglable en fonction de matériau d'évaporation (31) ou d'état de combustion de la cathode (32) ou en fonction d'un autre paramètre de fonctionnement de la source d'évaporation par arc sous vide.

11. Source d'évaporation par arc sous vide selon l'une des revendications précédentes, dans lequel la source de champ magnétique annulaire (2) ou l'anneau de champs magnétique de renforcement (4) ou l'anneau magnétique de correction (5) sont polarisés similairement en ce qui concerne la normale à la surface (300).

12. Source d'évaporation par arc sous vide selon l'une des revendications précédentes, dans lequel la source de champ magnétique annulaire (2) ou l'anneau de champs magnétique de renforcement (4) ou l'anneau magnétique de correction (5) sont polarisés inversement en ce qui concerne la normale à la surface (300).

13. Source d'évaporation par arc sous vide selon l'une des revendications précédentes, dans lequel la source de champ magnétique annulaire (2) ou l'anneau de champs magnétique de renforcement (4) ou l'anneau magnétique de correction (5) comprend un aimant à haute température, en particulier un aimant à haute température composé de SmCo.

14. Source d'évaporation par arc sous vide selon l'une des revendications précédentes, dans lequel la source de champ magnétique annulaire (2) est disposée à un bloc de support (7) et une isolation BN est prévue entre le bloc de support (7) et la cathode (32) pour limiter la décharge en arc à la surface d'évaporation (33) de la cathode (32), dans lequel le bloc de support (7) est principalement de cuivre.

15. Chambre d'évaporation par arc comprenant une source d'évaporation par arc sous vide (1) selon l'une des revendications 1 à 14.
